# EUROPÄISCHE PATENTANMELDUNG

(11) **EP 0 869 560 A2**
(43) Veröffentlichungstag der Anmeldung: **07.10.1998**
(21) Anmeldenummer: 98106152.6
(22) Anmeldetag: 03.04.1998
(51) Int. Cl.: H01L 29/864, H01L 29/861, H01L 29/06, H01L 27/08

(54) **Leistungsdiode**

(30) Priorität: 04.04.1997 DE 19713962
(71) Anmelder: SIEMENS AKTIENGESELLSCHAFT, 80333 München (DE)
(72) Erfinder: Taghizadeh-Kaschani, Karim-Thomas, Dr., 82008 Unterhaching (DE); Sittig, Roland, Prof, 38104 Braunschweig (DE)

(57) **Zusammenfassung**

Die Erfindung betrifft eine Read-Diode, bestehend aus einer Innenzone (2), einer Kathodenzone (3), einer Anodenzone (6) sowie einer zwischen der Innenzone (2) und der Anodenzone (6) angeordneten ersten Kopplungszone (5). Erfindungsgemäß ist zwischen der ersten Kopplungszone (5) und der Innenzone (2) eine zweite Kopplungszone (4) angeordnet. Beide Kopplungszonen (4) und (5) dienen im Sperrbetrieb zur Aufteilung des elektrischen Feldes in eine Hoch- und eine Niederfeldzone und erlauben somit im Spannungsdurchbruch eine stark lokalisierte Ladungsträgergeneration durch Stoßionisation. Die Verwendung der zwei Kopplungszonen (4) und (5) gewährleistet eine 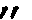 punch-through 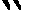 -Kopplung zwischen Hoch- und Niederfeldzone, die im Gegensatz zur Raumladungskopplung von Read-Dioden ein weitgehend temperaturunabhängiges 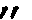 soft-recovery 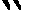 -Verhalten erlaubt. In einer Weiterbildung lassen sich aus diesen FCI-PT-Dioden Hybrid-Dioden mit optimiertem Durchlaß- und Abkommutierverhalten herstellen. Eine bevorzugte Anwendung finden FCI-PT-Dioden in Verbindung mit schaltenden Leistungshalbleiterbauelementen als Spannungsbegrenzer oder Freilaufdioden.

## Beschreibung

Die Erfindung betrifft eine Leistungsdiode bestehend aus einem Halbleiterkörper mit
- einer Innenzone vom ersten Leitungstyp,
- einer an die Innenzone anschließenden Kathodenzone vom ersten Leitungstyp und höherer Dotierungskonzentration als die Innenzone,
- zumindest einer an die Innenzone sich anschließenden ersten Kopplungszone vom ersten Leitungstyp, dessen Dotierungskonzentration höher ist als die der Innenzone und niedriger als die der Kathodenzone,
- einer an die erste Kopplungszone anschließenden Anodenzone vom zweiten Leitungstyp und höherer Dotierungskonzentration als in der ersten Kopplungszone.

Eine FCI-Diode (field-controlled-injection) der eingangs genannten Art ist beispielsweise als Read-Diode bekannt und von K. T. Kaschani und R. Sittig in 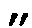 How to avoid TRAPATT-Oszillations at the Revers-Recovery of Power Diodes 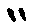 , CAS' 95, S. 571 - 574, Sinaia, 1995, beschrieben. Der Gegenstand dieser Druckschrift wird hiermit ausführlich in die vorliegende Anmeldung einbezogen ( 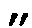 incorporated by reference 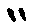 ).

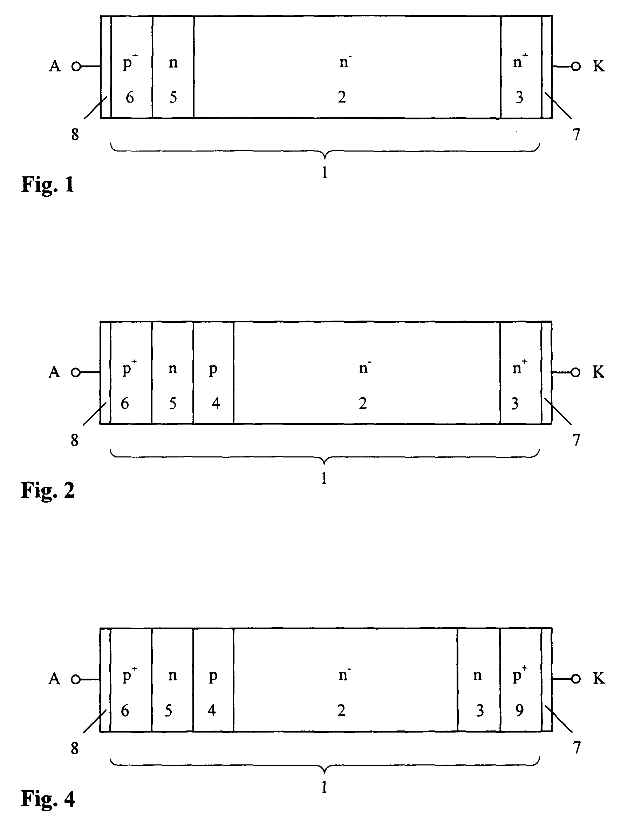

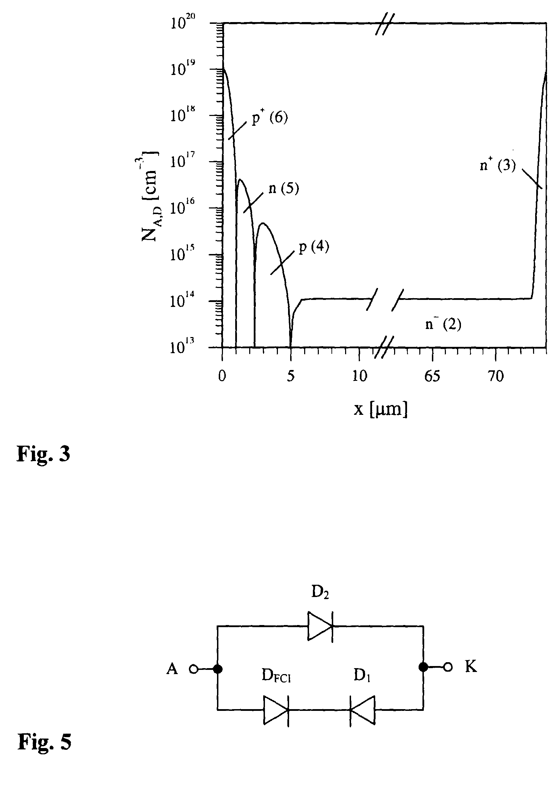

Die Read-Diode ist ursprünglich als Hochfrequenz-Bauelement für die Generierung von IMPATT-Schwingungen entwickelt worden. Im Folgenden wird in Figur 1 das FCI-Konzept anhand der bekannten Read-Diode in der speziellen Ausführung als pin-Leistungsdiode erläutert. Eine derartige Read-Diode ist insbesondere aus Figur 5 der oben erwähnten Druckschrift von Kaschani et al. bekannt.

Die pin-Leistungsdiode entsprechend Figur 1 zeigt einen Halbleiterkörper 1. Der Halbleiterkörper 1 besteht aus einer n⁻-dotierten Innenzone 2. Kathodenseitig ist an die Innenzone 2 die n⁺-dotierte Kathodenzone 3 angeordnet. Die Kathodenzone 3 ist über die Kathodenelektrode 7 mit dem Kathodenanschluß K verbunden. Anodenseitig schließt sich an die Innenzone 2 eine n-dotierte Kopplungszone 5 sowie eine p⁺-dotierte Anodenzone 6 an. Anodenseitig ist die Anodenzone 6 über die Anodenelektrode 8 mit dem Anodenanschluß A verbunden.

Wie aus der Figur 1 hervorgeht, ist bei der pin-Diode zwischen die Anodenzone 6 und die Innenzone 2 eine schmale Kopplungszone 5 eingebracht, die denselben Leitungstyp aufweist wie die Innenzone 2, aber stärker dotiert ist als die Innenzone 2. Aufgrund dieses Dotierungsprofils setzt sich das elektrische Feld im Sperrbetrieb aus einer sogenannten Hochfeldzone und einer sogenannten Niederfeldzone zusammen. Mit Hochfeldzone werden dabei Gebiete mit hoher elektrischer Feldstärke und mit Niederfeldzone Gebiete mit niedrigem elektrischen Feld bezeichnet.

Während sich die Hochfeldzone dabei auf den schmalen Bereich der Kopplungszone 5 unmittelbar vor der Anodenzone 6 beschränkt, erstreckt sich die Niederfeldzone nahezu homogen über die gesamte Innenzone 2. Entsprechend der Höhe der Dotierung ergibt sich allerdings auch eine deutlich höhere Durchbruchfeldstärke in der Hochfeldzone als in der Niederfeldzone (E_{BD,H} >> E_{BD,L}).

Um nun eine lokalisierte Lawinenmultiplikation beim Spannungsdurchbruch zu gewährleisten, ist die pin-Diode so dimensioniert, daß die Feldspitze in der Hochfeldzone zu diesem Zeitpunkt gerade ihre Durchbruchfeldstärke E_{BD,H} erreicht, während sich das Feldmaximum in der Niederfeldzone noch weit unterhalb seiner Durchbruchfeldstärke E_{BD,L} befindet. Wird daher die Durchbruchspannung V_{BD} überschritten, so kommt es zunächst nur in der Hochfeldzone zur Ladungsträgergeneration durch Lawinenmultiplikation.

Während die auf diese Weise generierten Löcher sofort an der angrenzenden, p⁺-dotierten Anodenzone 6 abfließen, müssen die Elektronen auf dem Weg zur n⁺-dotierten Kathodenzone 3 die gesamte Raumladungszone durchqueren. Die Elektronen bewegen sich dabei in der Hochfeldzone mit Sättigungsgeschwindigkeit und führen aufgrund ihrer negativen Ladung zu einer entsprechenden Kompensation der Raumladungen von Hochfeldzone und Niederfeldzone.

Die Wirkung dieser Kompensation auf beide Zonen ist jedoch unterschiedlich. So kommt es in der Hochfeldzone zu einer Verringerung der Feldspitze und zu einer Reduktion der Lawinenmultiplikation, was wiederum zu einer Abnahme des Elektronenstroms beziehungsweise seiner kompensierenden Wirkung auf die dortige Raumladung führt. Diese Gegenkopplung hat schließlich unabhängig von der anliegenden Überspannung eine Stabilisierung des Feldmaximums nahe der Durchbruchfeldstärke E_{BD,H} zur Folge.

Die Hochfeldzone dient daher sowohl zur Bereitstellung der erforderlichen Ladungsträger als auch zur erforderlichen Lokalisierung der Lawinenmultiplikation. In der Niederfeldzone dagegen führt die zunehmende Kompensation der Raumladung durch den mit steigender Überspannung anwachsenden Elektronenstrom zu einer Zunahme des Gradienten des elektrischen Feldes und damit zu einer entsprechenden Erhöhung des elektrischen Feldes, insbesondere vor der Kathodenzone 3.

Die Kopplung der elektrischen Felder von Hochfeldzone und der Niederfeldzone erfolgt bei der pin-Leistungsdiode entsprechend Figur 1 über die Raumladung der Kopplungszone 5. Die Raumladungskopplung hat sich jedoch für das Abkommutieren von Leistungsdioden als schwierig zu handhaben erwiesen, da die Raumladungskopplung sehr stark temperaturabhängig ist. Ein Einsatz von derartigen pin-Leistungsdioden in der Praxis ist demnach schwierig.

Aufgabe der vorliegenden Erfindung ist es daher, neue FCI-Dioden bereitzustellen, bei denen die Kopplung des elektrischen Feldes der Hochfeldzone mit der Niederfeldzone zu einer nahezu temperaturunabhängigen Durchbruchspannung führt.

Erfindungsgemäß wird diese Aufgabe durch Leistungsdioden der eingangs genannten Art gelöst, die dadurch gekennzeichnet sind, daß zwischen der ersten Kopplungszone und der Innenzone zumindest eine zweite Kopplungszone vom zweiten Leitungstyp vorgesehen ist, wobei die Dotierungskonzentration der zweiten Kopplungszone höher ist als die der Innenzone und niedriger als die der Anodenzone.

Derartige Leistungsdioden werden als FCI-Dioden mit 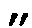 Punch-Trough 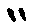 -Kopplung (FCI-PT-Dioden) bezeichnet. Unter Punch-Through-Kopplung wird verstanden, daß bei Sperrbetrieb das elektrische Feld in der Hochfeldzone und in der Niederfeldzone aufgrund der Wechselwirkungen beider Kopplungszonen durch den bekannten Punch-Through-Effekt gekoppelt sind.

Im Gegensatz zu Leistungsdioden der eingangs genannten Art weisen FCI-PT-Dioden eine aktive, kontrollierte Überspannungsbegrenzung auf, die weitgehend unabhängig von Speicherladung, Abkommutiersteilheit und Lebensdauereinstellung ist, zu keiner nennenswerten Beeinflussung des Durchlaßeigenschaften, Sperreigenschaften und des Einschaltverhaltens führt und obendrein noch eine deutliche Reduzierung der Schaltverluste erlaubt. Außerdem weisen die vorgestellten FCI-PT-Dioden gemäß der Erfindung im Gegensatz zu Leistungsdiode mit Raumladungskopplung eine temperaturunabhängige Durchbruchspannung auf, so daß der Abkommutiervorgang weitgehend temperaturunabhängig verläuft.

Vorteilhafterweise kann anodenseitig oder kathodenseitig eine weitere Zone zur Herstellung eines p-n-Überganges vorgesehen sein. Diese Zone hat typischerweise eine höhere Dotierungskonzentration als die sich ihr anschließende Anodenzone oder Kathodenzone. Auf diese Weise läßt sich eine Reihenschaltung aus einer FCI-PT-Diode und einer zu ihr in Sperrrichtung geschalteten weiteren Diode herstellen. Durch diese monolitisch integrierte, antiparallel angeordnete Diodenreihenschaltung läßt sich der Durchlaßbetrieb der FCI-PT-Diode unterdrücken, so daß sie nunmehr als reiner Spannungsbegrenzer fungiert.

Durch Parallelschaltung einer weiteren Diode läßt sich vorteilhafterweise daraus eine FCI-Hybrid-Dioden-Anordnung gewinnen, bei der im Durchlaßbetrieb nur die weitere Diode und im Sperrbetrieb nur die FCI-PT-Diode relevant ist. Handelt es sich bei der weiteren Diode um ein Bauelement mit optimiertem Durchlaßverhalten, so läßt sich auf diese Weise gleichzeitig eine Minimierung der Durchlaß- und der Schaltverluste sowie eine Optimierung des Abkommutierverlaufs erreichen.

Geometrisch gekoppelte Leistungsdioden können sehr vorteilhaft als Spannungsbegrenzer zur Unterdrückung transienter Überspannungen verwendet werden. Derzeitig verfügbare transiente Spannungsbegrenzer ( 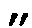 transient-voltage-supressor 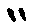 , TVS) sind auf Spannungen ≤ 500 V begrenzt. Andere vergleichbare Bauelemente, wie beispielsweise Varistoren, sprechen nicht schnell genug an, vertragen die mit häufig wiederkehrenden Spannungsspitzen verbundenen Verluste nicht oder altern schneller als erwünscht. Mit den erfindungsgemäßen Dioden lassen sich darüber hinaus auch Spannungsbegrenzter für Spannungen größer als 500 V bereitstellen.

Besonders vorteilhaft ist es auch, wenn die FCI-Dioden als einfache Read-Dioden ausgebildet sind. Dies ist dann möglich, wenn die Dotierungskonzentration der Kathodenzone sehr hoch gewählt wird. Auf diese Weise läßt sich die Temperaturabhängigkeit der Durchbruchsspannung nahezu kompensieren. Typischerweise weist dabei die Kathodenzone eine Dotierungskonzentration von etwa 10¹⁷ cm^{-³} auf. Voraussetzung hierfür ist jedoch eine deutlich höher dotierte Anodenzone.

Besonders vorteilhaft lassen sich die erfindungsgemäßen FCI-PT-Dioden als Freilaufdioden für Leistungshalbleiterbauelemente verwenden, wie beispielsweise in Parallelschaltung zu Bipolartransistoren, MOSFETS, IGBTs, GTOs, Thyristoren, MCTs etc.

Der kritischste Betriebszustand einer Leistungsdiode der eingangs genannten Art ist das Abkommutieren, das heißt der Wechsel vom Durchlaß- in den Sperrbetrieb. Beim Abkommutieren muß die im Durchlaßbetrieb zur Leitfähigkeitsmodulation der Innenzone benötigte Speicherladung in sehr kurzer Zeit wieder entfernt werden, um im Anschluß daran wieder Sperrspannung aufnehmen zu können. Dies geschieht über den sogenannten Rückstrom, der sich beim Wechsel in den Sperrbetrieb automatisch einstellt.

Aufgrund des Einflusses unvermeidbarer Streuinduktivitäten kann eine Leistungsdiode jedoch in der Praxis nur mit einer endlichen Steilheit abkommutiert werden. Um dabei hohe induktive Überspannungen sowie Oszillationen zu vermeiden, sollte eine Leistungsdiode ein möglichst weiches Abkommutierverhalten, genannt 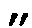 soft-recovery 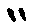 -Verhalten, aufweisen. Darunter versteht man insbesondere einen nach Erreichen der Rückstromspitze sanft abklingenden Rückstrom.

Das Abkommutierverhalten einer Leistungsdiode nach Erreichen der Rückstromspitze ist gekennzeichnet von der Notwendigkeit, die auf den maximalen Rückstrom aufgeladene Streuinduktivität wieder vollständig zu entladen. Um die dabei in der Diode auftretenden Verluste so gering wie möglich zu halten, soll dieser Entladevorgang so schnell wie möglich ablaufen. Gleichzeitig ist aber auch ein Soft-Recovery-Verhalten anzustreben. Das bedeutet eine Begrenzung der auftretenden induktiven Überspannungen sowie die Vermeidung jeglicher Oszillationen, da diese zur Beeinträchtigung bis hin zur Zerstörung benachbarter Bauelemente beziehungsweise der Leistungsdiode selbst führen können.

Eine Begrenzung der Überspannung hat jedoch zwangsläufig eine langsamere Entladung der Streuinduktivität und damit eine Erhöhung der Schaltverluste zur Folge, so daß sich im Zusammenhang mit der Minimierung von Überspannungen und Schaltverlusten grundsätzlich die Frage nach einem Kompromiß stellt. Es besteht allerdings die Möglichkeit, die Schaltverluste im Rahmen dieses Kompromisses bei vorgegebener maximaler Überspannung durch Variation des Strom- bzw. Spannungsverlaufes zu optimieren.

Die Maßnahmen zur Gewährleistung des angestrebten Soft-Recovery-Verhaltens lassen sich je nach Ansatzpunkt in interne und externe Maßnahmen unterscheiden.

Die externen Maßnahmen betreffen entsprechende Modifikationen des umgebenen Netzwerkes der Leistungsdiode oder deren Ansteuerung. Dazu gehört beispielsweise die Beschaltung der Leistungsdiode mit einem sogenannten 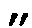 snubber 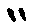 , das heißt einer Reihenschaltung, bestehend aus einem Widerstand und einer Kapazität. Damit soll das Abkommutierverhalten gedämpft werden. Allerdings führt ein snubber immer zu erhöhten Schaltverlusten, einem größeren Volumen und Gewicht des betreffenden Gerätes und schließlich zu höheren Kosten.

Ein anderer Weg, der zur Zeit zur Entlastung von Leistungsdioden und Gewährleistung eines Soft-Recovery-Verhaltens beschritten wird, besteht darin, die Schaltgeschwindigkeiten der beteiligten Halbleiterschalter zu drosseln und so das Abkommutierverhalten zu dämpfen. Dies würde der Einleitung des Abkommutiervorganges durch einen steuerbaren Widerstand an Stelle eines idealen Schalters entsprechen. Auf diese Weise gelingt es zwar, das Auftreten jeglicher Überspannung zu vermeiden und die jeweiligen Leistungsdioden spürbar zu entlasten. Gleichzeitig nehmen jedoch die Schaltverluste der beteiligten Halbleiterschalter stark zu.

Bei den internen Maßnahmen handelt es sich im wesentlichen um entsprechende Eingriffe in das Design von Leistungsdioden. Diese Eigriffe betreffen im wesentlichen die Optimierung des Dotierungsprofils oder der Lebensdauereinstellung.

Das Abkommutierverhalten einer Leistungsdiode bei den beschriebenen externen Maßnahmen wird maßgeblich von anderen Bauelementen bestimmt. Das führt in der Regel immer zu erhöhten Schaltverlusten. Außerdem ist unter diesen Umständen nur noch eine eingeschränkte Optimierung der Leistungsdiode möglich. Aufgrund dessen konzentriert sich die vorliegende Erfindung ausschließlich auf die Optimierung des Diodendesigns.

Üblicherweise wird versucht, ein sanftes Abkommutierverhalten durch Erweiterung der Innenzone und Bereitstellung eines zusätzlichen Ladungsträgerreservoirs, das bereits im Durchlaßbetrieb angelegt wird, zu erreichen. Dies führt jedoch bei den entsprechenden Dioden zu Innenzonenweiten, die gemessen an der zulässigen Sperrspannung überdimensioniert sind. Durch diese Überdimensionierung werden die Durchlaßspannungen beziehungsweise die Schaltverluste erhöht.

Ferner wird bei dieser Vorgehensweise nicht gewährleistet, daß das im Durchlaßbetrieb angelegte Ladungsträgerreservoir auch tatsächlich den Anforderungen des Abkommutiervorganges genügt. Ist das Ladungsträgerreservoir zu klein, so kommt es zum Abriß des Rückstromes und damit durch den Einfluß der Streuinduktivitäten zu erhöhten Überspannungen und durch die Induktivität verursachten, unerwünschten Oszillationen. Ist das Ladungsträgerreservoir dagegen zu groß, so kommt es zu entsprechend langsam abklingenden Rückströmen, den sogenannten 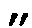 Tail-Strömen 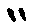 , und damit zu erhöhten Schaltverlusten.

Eine Alternative dazu ist die Begrenzung induktiver Überspannungen während des Abkommutiervorganges durch gezielte Generation von Ladungsträgern und damit durch kontrollierte Entladung der Streuinduktivität, sobald eine bestimmte Sperrspannung überschritten wird. Dieses Konzept wird 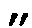 field-controlled-injection 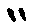 oder kurz FCI genannt. Als Mechanismus zur Erzeugung der erforderlichen Ladungsträger dient dabei die Stoßionisation, die ohnehin das Sperrvermögen einer Leistungsdiode nach oben hin begrenzt.

Durch das FCI-Konzept werden je nach Bedarf Ladungsträger generiert, so daß es automatisch zu einem Soft-Recovery-Verhalten kommt. Voraussetzung ist allerdings eine stark lokalisierte Ladungsträgergeneration, da es sonst zu TRAPATT-Oszillationen kommen kann.

Der grundsätzliche Vorteil des FCI-Konzepts besteht darin, daß keine Überdimensionierung der Innenzone erforderlich ist. Damit lassen sich Durchlaßverluste und Schaltverluste gegenüber den Leistungsdioden der eingangs genannten Art deutlich verringern.

Durch die vorliegende Erfindung werden also FCI-Dioden durch eine Punch-Through-Kopplung weitergebildet. Durch diese Punch-Through-Kopplung wird ihr Durchbruchverhalten und damit auch ihr Soft-Recovery-Verhalten weitgehend temperaturunabhängig.

Die Erfindung wird nachfolgend anhand der in den Figuren der Zeichnung angegebenen Ausführungsbeispiele näher erläutert. Es zeigt:
- Figur 1: einen Querschnitt durch den Halbleiterkörper einer pin-Leistungsdiode mit Raumladungskopplung (Read-Diode) nach dem Stand der Technik;
- Figur 2: einen Querschnitt durch den Halbleiterkörper einer erfindungsgemäßen FCI-Diode mit Punch-Through-Kopplung;
- Figur 3: ein Beispiel für das Dotierungsprofil einer FCI-Diode mit Punch-Through-Kopplung entsprechend Figur 2;
- Figur 4: einen Querschnitt durch den Halbleiterkörper einer FCI-Diode mit Punch-Through-Kopplung und kathodenseitig integrierter Sperrdiode;
- Figur 5: ein Schaltbild einer FCI-Hybrid-Diode als eine bevorzugte Anwendung einer FCI-Diode mit Punch-Through-Kopplung.

Figur 2 zeigt den Querschnitt durch den Halbleiterkörper einer erfindungsgemäßen FCI-Diode mit Punch-Through-Kopplung. Gleiche Elemente sind entsprechend Figur 1 mit gleichen Bezugszeichen versehen.

Die Leistungsdiode entsprechend Figur 2 enthält im wesentlichen die Elemente der Read-Diode aus Figur 1: eine n⁻-dotierte Innenzone 2, eine n⁺-dotierte Kathodenzone 3, eine n-dotierte erste Kopplungszone 5 und eine p⁺-dotierte Anodenzone 6. Anodenseitig und kathodenseitig ist die FCI-Diode jeweils mit einem Anodenanschluß A beziehungsweise einen Kathodenanschluß K verbunden. Gegenüber Figur 1 ist in Figur 2 jedoch zusätzlich zwischen der Innenzone 2 und der ersten Kopplungszone 5 eine zweite p-dotierte Kopplungszone 4 angeordnet.

Derartig ausgestaltete Leistungsdioden werden nachfolgend als FCI-Dioden mit Punch-Through-Kopplung (FCI-PT-Kopplung) bezeichnet.

Die Funktionsweise der erfindungsgemäßen zweiten Kopplungszone 4 bei FCI-Dioden der eingangs genannten Art wird nachfolgend erläutert.

Im Sperrbetrieb wird durch die Einführung eines zusätzlichen p-n-Überganges durch die zweite Kopplungszone 4 die Hochfeldzone von der Niederfeldzone räumlich getrennt. Die Hochfeldzone wird dabei vom hochdotierten p-n-Übergang zwischen der Anodenzone 6 und der ersten Kopplungszone 5 gebildet. Die Niederfeldzone erstreckt sich dagegen von der zweiten Kopplungszone 4 über die Innenzone 2 bis zur Kathodenzone 3. Die Kopplung von Hochfeldzone und Niederfeldzone wird hier durch einen 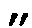 Punch-Through 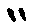 der zusätzlich eingebrachten zweiten Kopplungszone 4 von seiten der Niederfeldzone erzeugt.

Bei einer FCI-PT-Diode ist es daher von großer Bedeutung, daß mit Erreichen der angestrebten Durchbruchspannung die neutrale Weite der zweiten Kopplungszone, im Vergleich zur Diffusionslänge der dortigen Minoritätsladungsträger, nicht groß ist. Es würde sonst nicht zu einer Punch-Through-Kopplung, sondern zu einer Stromkopplung kommen, bei der sich die Sperrspannung nach Maßgabe des Sperrstromes über der Hochfeldzone und der Niederfeldzone verteilt und bei der ein definierter Spannungsdurchbruch mit lokalisierter Lawinenmultiplikation nicht mehr möglich ist.

Figur 3 zeigt ein mögliches Dotierungsprofil einer FCI-PT-Diode entsprechend Figur 2. Die p⁺-dotierte Anodenzone ist im vorliegenden Beispiel 1 µm breit und weist eine maximale Dotierungskonzentration von 10¹⁹ cm⁻³ auf. Die sich daran anschließende n-dotierte erste Kopplungszone 5 ist etwa 1,4 µm breit und weist eine maximale Dotierungskonzentration von 4 x 10¹⁶ cm⁻³ auf. Die p-dotierte zweite Kopplungszone 4 ist etwa 2,6 µm breit und weist eine maximale Dotierungskonzentration von etwa 5 x 10¹⁵ cm⁻³ auf. Kathodenseitig ist die n⁺-dotierte Kathodenzone 3 etwa 1 µm breit und weist eine maximale Dotierungskonzentration von 10¹⁹ cm⁻³ auf. Die n⁻-dotierte Innenzone 2 des Halbleiterkörpers 1 weist im vorliegenden Beispiel eine Dotierungskonzentration von etwa 10¹⁴ cm⁻³ auf und ist etwa 68 µm breit.

Figur 4 zeigt eine entsprechend Figur 2 weitergebildete FCI-PT-Diode. Gleiche Elemente sind entsprechend der vorhergehenden Figuren mit gleichen Bezugszeichen versehen.

Die FCI-PT-Diode entsprechend Figur 2 wurde in Figur 4 derart weitergebildet, daß kathodenseitig eine weitere p⁺-dotierte Zone 9 zwischen Kathodenanschluß K und Kathodenzone 3 vorgesehen ist. Durch das Hinzufügen einer zusätzlichen Zone 9 in den Halbleiterkörper aus Figur 2 wird ein zusätzlicher p-n-Übergang erzeugt. Auf diese Weise läßt sich ein monolithisch integriertes Halbleiterbauelement bestehend aus zwei antiparallelen und in Reihe geschalteten Dioden herstellen.

Grundsätzlich ist bei Erzeugung eines zusätzlichen p-n-Überganges durch Einfügung einer zusätzlichen Zone 9 in die FCI-Diode entsprechend Figur 2 darauf zu achten, daß die Diode des betreffenden neu erzeugten p-n-Überganges antiparallel und in Reihe zu der FCI-Diode geschaltet ist. Darüberhinaus ist zu beachten, daß die Durchbruchspannung des zusätzlichen p-n-Überganges ausreichend hoch dimensioniert ist, um einen Stromfluß in Durchlaßrichtung zu verhindern. Aus diesem Grund ist im vorliegenden Beispiel die Kathodenzone 3 niedriger dotiert als die weitere Zone 9. Schließlich ist darauf zu achten, daß die an die weitere Zone 9 angrenzende Kathodenzone 3 weit genug dimensioniert ist, so daß es nicht zum 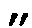 punch-through 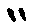 der weiteren Zone 9 kommt. In diesem Fall würde die sperrende Wirkung des zusätzlichen p-n-Überganges außer Kraft gesetzt werden.

Es ist selbstverständlich auch denkbar, die zusätzliche Zone 9 anodenseitig zwischen der Anodenzone 6 und der Anodenelektrode 8 anzuordnen. Die anodenseitige zusätzliche Zone müßte in diesem Fall n⁺-dotiert sein und die Anodenzone 6 müßte ausreichend weit dimensioniert sein.

Ein zusätzlicher p-n-Übergang zur Realisierung von zwei antiparallel geschalteten Dioden läßt sich selbstverständlich auch durch einen anodenseitigen oder kathodenseitigen Schottky-Kontakt anstelle einer weiteren Zone 9 erzeugen.

Figur 5 zeigt ein Schaltbild einer FCI-Hybrid-Diode als eine vorteilhafte Anwendung der FCI-PT-Diode entsprechend der Figuren 2 und 4. Zwischen einem Anodenanschluß A und einem Kathodenanschluß K befindet sich die Parallelschaltung aus der Diode D₂ und der Diode D_{FCI}. Die Diode D₂ ist dabei beispielsweise eine auf gutes Durchlaßverhalten optimierte Leistungsdiode. Die FCI-Diode D_{FCI} hat die Funktion eines Spannungsbegrenzers und ist nur im Sperrbetrieb wirksam. Im Durchlaßbetrieb ist die Diode D_{FCI} durch die in Reihe und antiparallel dazu geschaltete Diode D₁ gesperrt. Somit ist im Durchlaßbetrieb die Diode D₂ und im Sperrbetrieb die Diode D_{FCI} relevant.

Die Dioden D₁, D₂ und D_{FCI} lassen sich als monolitisch integriertes Halbleiterbauelement realisieren. Es ist allerdings auch eine diskrete Realisierung der Bauelemente denkbar. Die Vorteile einer monolitisch integrierten Anordnung liegen in einem induktivitätsarmen Aufbau, der insbesondere die Reduktion der Schaltverluste erlaubt.

Besonders vorteilhaft ist die Anwendung von FCI-PT-Dioden als Freilaufdioden oder Spannungsbegrenzer in Parallelschaltung zu abschaltbaren Leistungshalbleiterbauelementen, wie beispielsweise Bipolartransistoren, MOSFETS, IGBTs, GTOs, Thyristoren, MCTs, etc. Dabei ist sowohl eine monolithische Integration als auch ein hybrider oder diskreter Aufbau denkbar.

Ein besonderer Vorteil der Erfindung ist schließlich, daß die erfindungsgemäßen FCI-Dioden auch als einfache Dioden mit Read-Struktur ausgeführt sein können. Dies war bislang nicht möglich, da derartige Read-Dioden eine sehr starke Temperaturabhängigkeit ihrer Durchbruchsspannung aufweisen. Die Ursache für die starke Temperaturabhängigkeit der Durchbruchspannung liegt in der Temperaturabhängigkeit der Stoßionisation, die im Spannungsdurchbruch innerhalb der Hochfeldzone auftritt und sich aufgrund der konstanten Raumladung dieser Hochfeldzone besonders stark auf die Feldstärke der angrenzenden, deutlich breiter dimensionierten Niederfeldzone und somit auf die Durchbruchsspannung der Diode auswirkt. Um dieses Problem der Raumladungskopplung zu umgehen, wurden bislang äußerst komplizierte Strukturen vorgeschlagen, bei denen die Feldstärken der Hochfeldzonen und Niederfeldzonen nicht über eine konstante Raumladung, sondern über die Ausnutzung des "punch-through"-Effektes bzw. durch Geometrieeffekte wie oben beschrieben gekoppelt wurden.

Erfindungsgemäß lassen sich FCI-Dioden mit Read-Struktur über die Dotierungskonzentration in der n⁺-dotierten Kathodenzone 3 realisieren. Über die Höhe der Dotierungskonzentration der Kathodenzone 3 ist es somit möglich, ähnlich wie bei Kleinleistungsdioden den Tunnel-Effekt am p-n-Übergang zwischen der p-dotierten Anodenzone 6 und der n-dotierten Kathodenzone 3 zu begünstigen.

Da der Tunnel-Effekt über einen der Stoßionisation entgegengesetzten Temperaturkoeffizienten verfügt, kann über die Höhe der Dotierungskonzentration in der Kathodenzone 3 der Temperaturkoeffizient der Durchbruchspannung der als Read-Diode aufgeführten FCI-Diode nahezu beliebig eingestellt werden. Es ist somit zu erwarten, daß sich beispielsweise bei einer Dotierungskonzentration der Kathodenzone 3 von etwa 10¹⁷ cm⁻³ eine Durchbruchsspannung der als Read-Diode ausgeführten FCI-Diode mit schwach positiven Temperaturkoeffizienten einstellen läßt. Damit kann eine Stromfilamentierung vermieden werden und ein sicherer Betrieb gewährleistet werden. Voraussetzung hierfür ist jedoch eine gegenüber der Kathodenzone 3 deutlich höher dotierte Anodenzone 6.

Durch die Erfindung ist es somit auf technologisch sehr einfache Weise möglich, eine FCI-Diode in der sehr einfachen Struktur einer Read-Diode auszuführen. Die Temperaturabhängigkeit der Durchbruchsspannung läßt sich dabei beliebig einstellen und demzufolge auch kompensieren.

## Patentansprüche

1. Leistungsdiode bestehend aus einem Halbleiterkörper (1) mit
- einer Innenzone (2) vom ersten Leitungstyp,
- einer an die Innenzone (2) anschließenden Kathodenzone (3) vom ersten Leitungstyp und höherer Dotierungskonzentration als die Innenzone (2),
- zumindest einer an die Innenzone (2) sich anschließenden ersten Kopplungszone (5) vom ersten Leitungstyp, dessen Dotierungskonzentration höher ist als die der Innenzone (2) und niedriger als die der Kathodenzone (3),
- einer an die erste Kopplungszone (5) anschließenden Anodenzone (6) vom zweiten Leitungstyp und höherer Dotierungskonzentration als in der ersten Kopplungszone (5),
**dadurch gekennzeichnet,** daß
zwischen der ersten Kopplungszone (5) und der Innenzone (2) zumindest eine zweite Kopplungszone (4) vom zweiten Leitungstyp vorgesehen ist, wobei die Dotierungskonzentration der zweiten Kopplungszone (4) höher ist als die der Innenzone (2) und niedriger als die der Anodenzone (6).

2. Leistungsdiode nach Anspruch 1,
**dadurch gekennzeichnet,** daß
im Halbleiterkörper (1) zumindest eine zur Leistungsdiode antiparallel und in Reihe geschaltete zweite, monolithisch integrierte Diode vorgesehen ist.

3. Hybrid-Dioden-Anordnung mit einer Leistungsdiode nach einem der vorherigen Ansprüche.

4. Spannungsbegrenzer mit einer Leistungsdiode nach einem der vorherigen Ansprüche.

5. Freilaufdiode mit einer Leistungsdiode nach einem der Ansprüche 1 - 3.

6. Leistungsdiode nach einem der vorhergehenden Ansprüche mit einer Read-Diodenstruktur.

7. Leistungsdiode nach einem der vorherigen Ansprüche in Parallelschaltung zu einem Leistungshalbleiterbauelement.
